# EUROPEAN PATENT APPLICATION

(11) **EP 4 697 924 A1**
(43) Date of publication of application: **18.02.2026**
(21) Application number: 25190846.3
(22) Date of filing: 22.07.2025
(51) Int. Cl.: H10W 74/01, H10W 74/10, H10W 70/62, H10W 29/00

(54) **SEMICONDUCTOR DEVICE PACKAGING WARPAGE CONTROL**

(30) Priority: 15.08.2024 US 202418805729
(71) Applicant: NXP USA, Inc., Austin, TX 78735 (US)
(72) Inventor: Lim, Hock Fu, 5656AG Eindhoven (NL); Tan, Cai Hui, 5656AG Eindhoven (NL)
(74) Representative: Colaiuda, Antonella

(57) **Abstract**

A method of manufacturing a semiconductor device packaging panel is provided. The method includes forming a packaging substrate having a plurality of grooves orthogonally arranged and substantially surrounding a plurality of package sites. A plurality of semiconductor die is affixed on a first major side of the packaging substrate. Each semiconductor die of the plurality of semiconductor die is affixed at a unique package site of the plurality of package sites. An encapsulant encapsulates the first major side of the packaging substrate such that each semiconductor die of the plurality of semiconductor die is encapsulated by the encapsulant. A singulation cut is formed along each groove of the plurality of grooves of the packaging substrate to form individual semiconductor device units.

## Description

### Background

### Field

This disclosure relates generally to semiconductor device packaging, and more specifically, to semiconductor device packaging warpage control.

### Related Art

Today, many electronic products include semiconductor devices formed from panel-level packaging of semiconductor die. With panel-level packaging, connections to the semiconductor die may be formed after panel encapsulation. After encapsulation, there is a problem referred to as panel warping that can occur as an effect of the encapsulation, redistribution, or other process steps, for example. Warping is of particular concern in panel-level packaging as forming connections to the semiconductor die can be difficult thus affecting yield, reliability, costs, and panel handling through processing. Therefore, it is desirable to overcome problems associated with panel-level warpage.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified plan view, an example semiconductor device packaging panel at a stage of manufacture in accordance with an embodiment.
FIG. 2 through FIG. 5 illustrate, in simplified cross-sectional views, a portion of the example semiconductor device packaging panel at stages of manufacture in accordance with an embodiment.
FIG. 6 through FIG. 8 illustrate, in simplified cross-sectional views, a portion of an alternative example semiconductor device packaging panel at stages of manufacture in accordance with an embodiment.

### Detailed Description

Generally, there is provided, a semiconductor device packaging process for panel warpage control. The packaging process for a panel includes a forming a plurality of grooves on a packaging substrate of the panel. The packaging substrate of the panel includes a plurality of packaging sites arranged in a grid of rows and columns. Each packaging site corresponds to a singulated individual semiconductor device unit after subsequent stages of manufacture, for example. The plurality of grooves is configured and arranged to surround each individual packaging site of the packaging substrate. The grooves are formed having predetermined width and depth dimensions chosen to compensate for coefficient of thermal expansion (CTE) mismatches and thereby control panel warpage during subsequent stages of manufacture. A plurality of semiconductor die is mounted on the packaging substrate such that each packaging site includes at least one semiconductor die. Each semiconductor die of the plurality of semiconductor die is interconnected with conductive features of the packaging substrate. An encapsulant is formed over the plurality of semiconductor die and the top side of the packaging substrate. Singulation cuts are formed along the grooves to singulate the package sites and form the individual semiconductor device units. By forming semiconductor device panels in this manner, panel warpage is substantially controlled and mitigated with minimal costs.

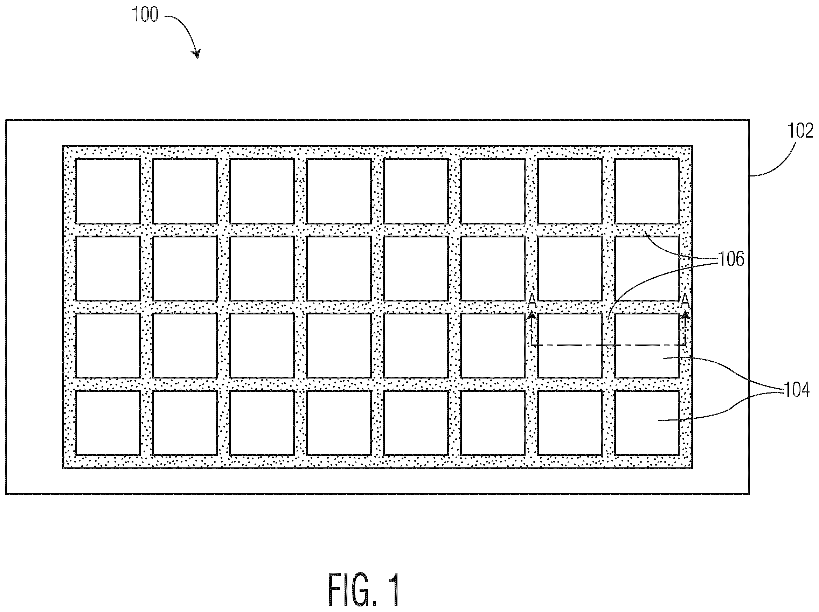

FIG. 1 illustrates, in a simplified plan view, an example semiconductor device packaging panel 100 at a stage of manufacture in accordance with an embodiment. At this stage, the panel 100 includes a packaging substrate 102 having a plurality of grooves 106 surrounding a plurality of package sites 104. Each package site 104, illustrated in FIG. 1 as an approximate outer perimeter outline, is representative of an of an individual semiconductor device unit (e.g., after subsequent stages of manufacture and singulation). In this embodiment, the package sites 104 of the panel 100 are arranged in an array of four rows by 8 columns. The grooves 106 are orthogonally arranged and configured to substantially surround each package site 104 of the plurality. In this embodiment, the grooves 106 are formed as a continuous groove surrounding each package site 104 of the panel 100. In some embodiments, the grooves 106 surrounding each package site 104 of the panel 100 may be segmented or otherwise discontinuous. The grooves 106 may be formed by way of laser ablation or mechanical sawing processes, for example, such that the grooves 106 do not extend through the packaging substrate 102. Predetermined singulation lanes (not shown) of package sites are arranged substantially coincident with the plurality of grooves 106. In this embodiment, 32 package sites 104 are depicted. In other embodiments, the panel 100 may include fewer than 32 package sites or more than 32 package sites.

The packaging substrate 102 has a top major surface and a bottom major surface. The packaging substrate 102 is configured and arranged for attachment and interconnection of semiconductor die at a subsequent stage of manufacture. In this embodiment, the packaging substrate 102 is formed as a non-conductive laminate substrate material with embedded conductive traces (not shown). The term "conductive," as used herein, generally refers to electrical conductivity unless otherwise described. The packaging substrate 102 may be formed in any suitable panel shape such as rectangular, square, or round, for example.

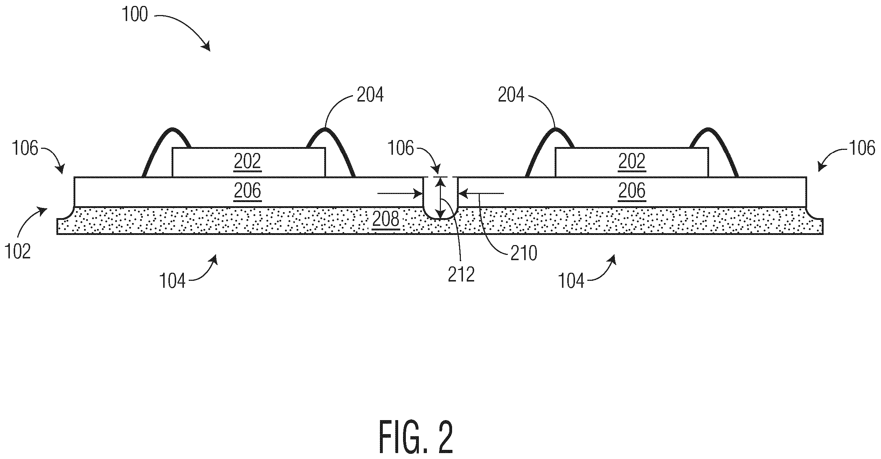

FIG. 2 through FIG. 5 illustrate, in simplified cross-sectional views, a portion of the example semiconductor device packaging panel 100 at stages of manufacture in accordance with an embodiment. Cross-sectional views of two adjacent package sites 104 of the panel 100 taken along line A-A are shown at example stages of manufacture depicted in FIG. 2 through FIG. 5.

FIG. 2 illustrates, in a simplified cross-sectional view, the two-package site portion of the example semiconductor device packaging panel 100 at a subsequent stage of manufacture in accordance with an embodiment. At this stage, the panel 100 includes a plurality of semiconductor die 202 mounted on the packaging substrate 102. In this embodiment, each semiconductor die 202 is affixed at a unique respective package site 104 such that each package site 104 of the panel 100 includes at least one semiconductor die 202. The semiconductor die 202 may be affixed to the packaging substrate 102 by way of a die attach material (not shown). The die attach material may be in the form of a paste, film (e.g., die attach film, DAF), or other suitable die attach material.

The semiconductor die 202 has an active surface (e.g., major surface having circuitry) and a backside surface (e.g., major surface opposite of the active surface). The semiconductor die 202 includes bond pads (not shown) at the active surface configured for connection to conductive features (not shown) of the packaging substrate 102 by way of bond wires 204, for example. The semiconductor die 202 may be formed from any suitable semiconductor material, such as silicon, germanium, gallium arsenide, gallium nitride and the like. The semiconductor die 202 may further include any digital circuits, analog circuits, RF circuits, memory, signal processor, MEMS, sensors, the like, and combinations thereof.

In this embodiment, the packaging substrate 102 is formed as a laminate structure. For example, the packaging substrate 102 includes a top core (e.g., FR4) layer 206 and a dielectric layer 208 (e.g., solder mask) formed on a bottom side of the core layer. Patterned conductive layers (e.g., copper traces) embedded within laminate structure of the packaging substrate 102 is not shown for illustration purposes. Even though the packaging substrate 102 is depicted in a two-layer laminate configuration, embodiments with other multi-layer laminate configurations are anticipated by this disclosure. In this embodiment, the grooves 106 are formed at the top major surface of the packaging substrate 102 and do not extend through the packaging substrate 102. For example, a portion of the dielectric layer 208 remains between a bottom of the grooves and the bottom major surface of the packaging substrate 102 in this embodiment. The grooves 106 are formed having a predetermined width dimension 210 and a predetermined depth dimension 212. In this embodiment, the width dimension 210 and the depth dimension 212 are chosen to compensate for coefficient of thermal expansion (CTE) mismatches and thereby control warpage of the panel 100 over subsequent stages of manufacture. The grooves 106 are configured to substantially surround each package site 104 in this embodiment.

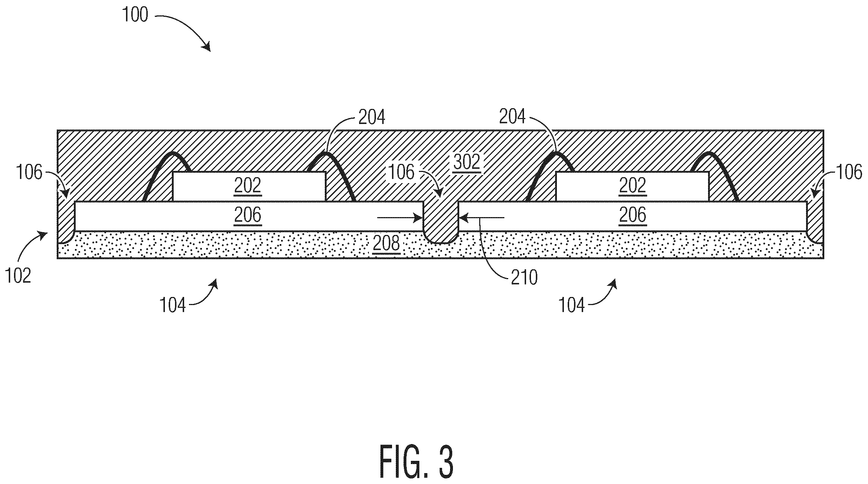

FIG. 3 illustrates, in a simplified cross-sectional view, the two-package site portion of the example semiconductor device packaging panel 100 at a subsequent stage of manufacture in accordance with an embodiment. At this stage, the panel 100 includes an encapsulant 302 (e.g., epoxy material) formed over the plurality of semiconductor die 202 and the top major surface of the packaging substrate 102. In this embodiment, the top side of the panel 100 including the semiconductor die 202 mounted on the packaging substrate 102 are over-molded with the encapsulant 302 during an encapsulation operation. The grooves 106 at the top major surface of the packaging substrate 102 are filled with the encapsulant 302 by way of the encapsulation operation in this embodiment.

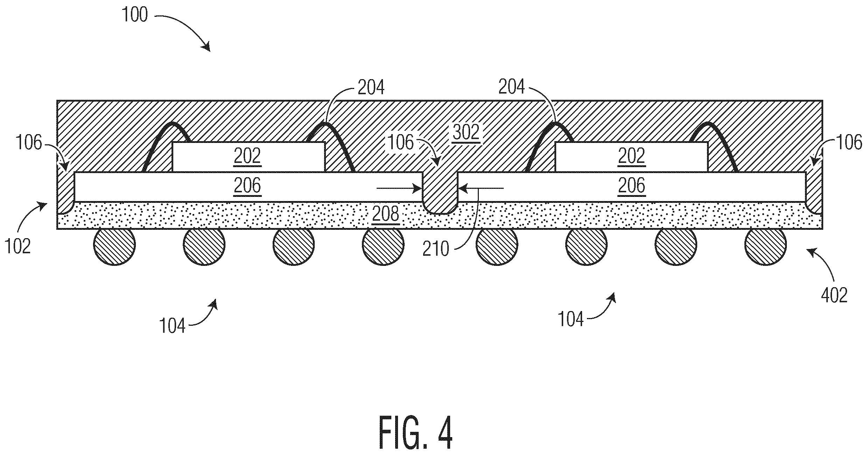

FIG. 4 illustrates, in a simplified cross-sectional view, the two-package site portion of the example semiconductor device packaging panel 100 at a subsequent stage of manufacture in accordance with an embodiment. At this stage, the panel 100 includes a plurality of conductive package connectors 402 (e.g., solder balls) affixed at the bottom side of the panel. In this embodiment, the plurality of conductive package connectors 402 are conductively connected to exposed conductive features (not shown) at the bottom major surface of the packaging substrate 102. In this embodiment, the plurality of conductive package connectors 402 are configured in a ball grid array (BGA) arrangement. The conductive package connectors 402 are configured and arranged to provide conductive connections between the (singulated) packaging substrate 102 and a PCB at a subsequent stage, for example. Accordingly, the semiconductor die 202 may be interconnected with the PCB by way of the conductive features of the package substrate 102. In this embodiment, the conductive package connectors 402 are in the form of solder balls. In other embodiments, the conductive package connectors 402 may be in the form of other suitable conductive structures such as gold studs, copper pillars, and the like.

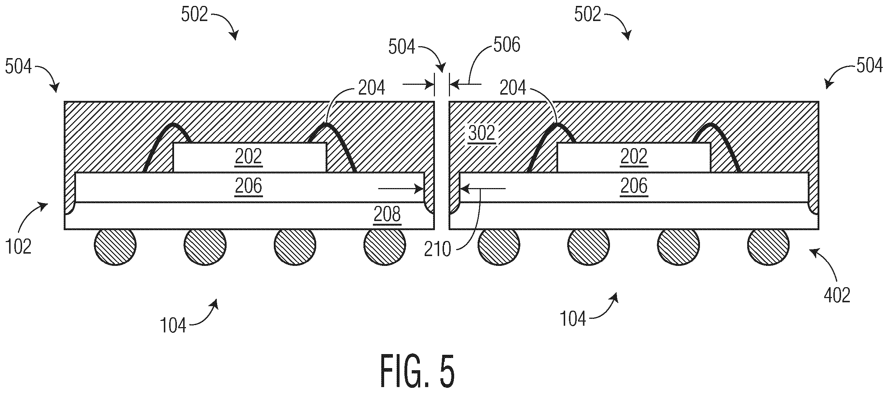

FIG. 5 illustrates, in a simplified cross-sectional view, the two-package site portion of the example semiconductor device packaging panel 100 at a subsequent stage of manufacture in accordance with an embodiment. At this stage, the panel 100 is completed and singulated into individual semiconductor device units 502. In this embodiment, a singulation cut 504 is formed along each groove (106 of FIG. 4) to singulate the package sites (104 of FIG. 4) and form the individual semiconductor device units 502. The singulation cuts 504, having a predetermined width dimension 506, are formed through the encapsulant and grooves of the package substrate 102. In this embodiment, the width dimension 504 of the singulation cuts is narrower than the width dimension 210 of the grooves. Accordingly, a portion of the encapsulant 302 substantially surrounds an upper portion of the packaging substrate 102 of the individual semiconductor device units 502.

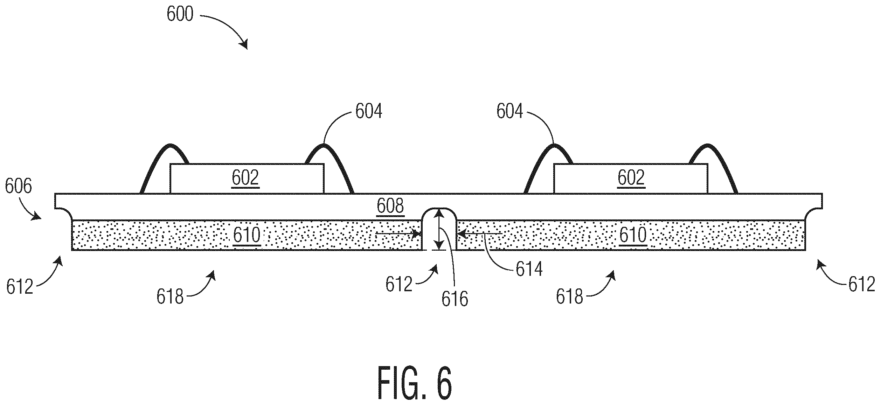

FIG. 6 through FIG. 8 illustrate, in simplified cross-sectional views, a portion of an alternative example semiconductor device packaging panel 600 at stages of manufacture in accordance with an embodiment. Cross-sectional views of two adjacent package sites of the panel 600 are shown at example stages of manufacture depicted in FIG. 6 through FIG. 8.

FIG. 6 illustrates, in a simplified cross-sectional view, the two-package site portion of the example semiconductor device packaging panel 600 at a stage of manufacture in accordance with an embodiment. At this stage, the panel 600 includes a plurality of semiconductor die 602 mounted on the packaging substrate 606. In this embodiment, each semiconductor die 602 is affixed at a unique respective package site 618 such that each package site 618 of the panel 600 includes at least one semiconductor die 602. The semiconductor die 602 may be affixed to the packaging substrate 606 by way of a die attach material (not shown). The die attach material may be in the form of a paste, film (e.g., die attach film, DAF), or other suitable die attach material.

The semiconductor die 602 has an active surface (e.g., major surface having circuitry) and a backside surface (e.g., major surface opposite of the active surface). The semiconductor die 602 includes bond pads (not shown) at the active surface configured for connection to conductive features (not shown) of the packaging substrate 606 by way of bond wires 604, for example. The semiconductor die 602 may be formed from any suitable semiconductor material, such as silicon, germanium, gallium arsenide, gallium nitride and the like. The semiconductor die 602 may further include any digital circuits, analog circuits, RF circuits, memory, signal processor, MEMS, sensors, the like, and combinations thereof.

The packaging substrate 606 has a top major surface and a bottom major surface. In this embodiment, the packaging substrate 606 is formed as a laminate structure. For example, the packaging substrate 606 includes a top core (e.g., FR4) layer 608 and a dielectric layer 610 (e.g., solder mask) formed on a bottom side of the core layer. Patterned conductive layers (e.g., copper traces) embedded within laminate structure of the packaging substrate 606 is not shown for illustration purposes. In this embodiment, grooves 612 are formed at the bottom major surface of the packaging substrate 606 and do not extend through the packaging substrate 606. For example, a portion of the core layer 608 remains between a bottom of the grooves 612 and the top major surface of the packaging substrate 606 in this embodiment. The grooves 612 are formed having a predetermined width dimension 614 and a predetermined depth dimension 616. In this embodiment, the width dimension 614 and the depth dimension 616 are chosen to compensate for coefficient of thermal expansion (CTE) mismatches and thereby control warpage of the panel 600 over subsequent stages of manufacture. The grooves 612 are configured to substantially surround each package site 618 in this embodiment.

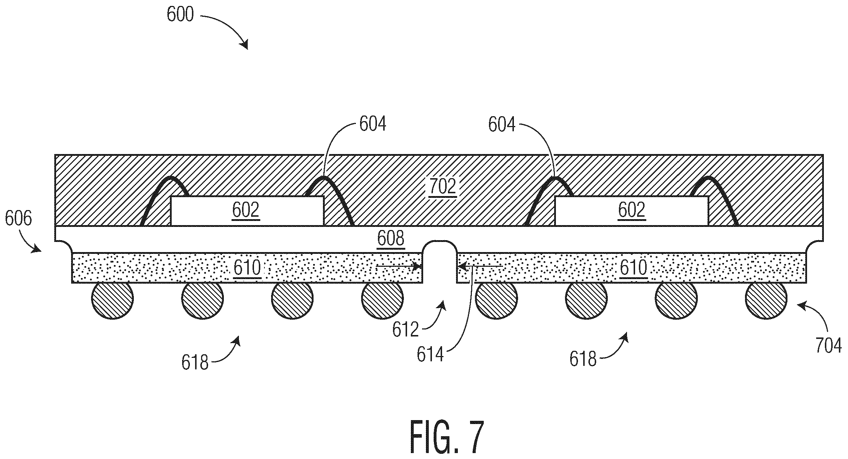

FIG. 7 illustrates, in a simplified cross-sectional view, the two-package site portion of the example semiconductor device packaging panel 600 at a subsequent stage of manufacture in accordance with an embodiment. At this stage, the panel 600 includes an encapsulant 702 (e.g., epoxy material) formed over the plurality of semiconductor die 602 and the top major surface of the packaging substrate 606, and a plurality of conductive package connectors 704 (e.g., solder balls) affixed at the bottom side of the panel. In this embodiment, the top side of the panel 600 including the semiconductor die 602 mounted on the packaging substrate 606 are over-molded with the encapsulant 702 during an encapsulation operation. The grooves 612 formed at the bottom major surface of the packaging substrate 606 remain empty (e.g., not filled with the encapsulant 702) during the encapsulation operation in this embodiment.

In this embodiment, the plurality of conductive package connectors 704 are conductively connected to exposed conductive features (not shown) at the bottom major surface of the packaging substrate 606. In this embodiment, the plurality of conductive package connectors 704 are configured in a BGA arrangement. The conductive package connectors 704 are configured and arranged to provide conductive connections between the (singulated) packaging substrate 606 and a PCB at a subsequent stage, for example. Accordingly, the semiconductor die 602 may be interconnected with the PCB by way of the conductive features of the package substrate 606. In this embodiment, the conductive package connectors 704 are in the form of solder balls. In other embodiments, the conductive package connectors 704 may be in the form of other suitable conductive structures such as gold studs, copper pillars, and the like.

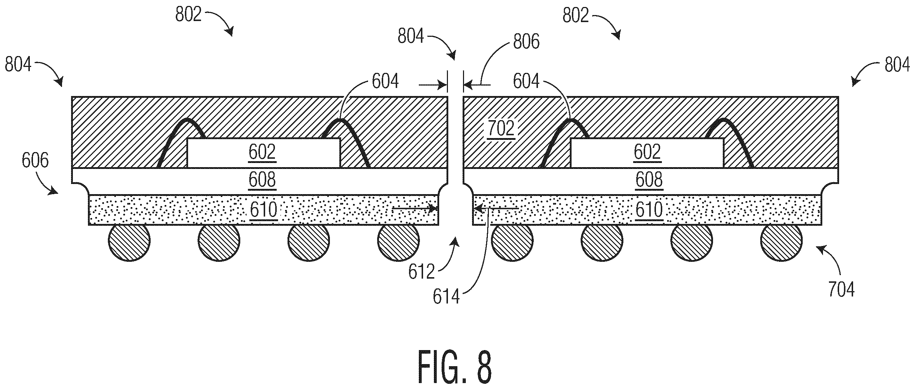

FIG. 8 illustrates, in a simplified cross-sectional view, the two-package site portion of the example semiconductor device packaging panel 600 at a subsequent stage of manufacture in accordance with an embodiment. At this stage, the panel 600 is completed and singulated into individual semiconductor device units 802. In this embodiment, a singulation cut 804 is formed along each groove 612 to singulate the package sites (618 of FIG. 7) and form the individual semiconductor device units 802. The singulation cuts 804, having a predetermined width dimension 806, are formed through the encapsulant and grooves of the package substrate 606. In this embodiment, the width dimension 804 of the singulation cuts is narrower than the width dimension 614 of the grooves.

Generally, there is provided, a method of manufacturing a semiconductor device packaging panel including forming a packaging substrate having a plurality of grooves orthogonally arranged and substantially surrounding a plurality of package sites; affixing a plurality of semiconductor die on a first major side of the packaging substrate, each semiconductor die of the plurality of semiconductor die affixed at a unique package site of the plurality of package sites; encapsulating with an encapsulant the first major side of the packaging substrate, each semiconductor die of the plurality of semiconductor die encapsulated by the encapsulant; and forming a singulation cut along each groove of the plurality of grooves of the packaging substrate to form individual semiconductor device units. The plurality of grooves may be formed on the first major side of the packaging substrate. Each semiconductor die of the plurality of semiconductor die may be interconnected to the packaging substrate by way of bond wires. A width of the singulation cut may be narrower than a width of each groove of the plurality of grooves. The packaging substrate may include a core layer and a solder mask layer, the core layer proximate to the first major side. Each groove of the plurality of grooves may extend through the core layer of the packaging substrate. A portion of the encapsulant may encapsulate sidewalls of the core layer after the singulation cut. The method may further include affixing a plurality of conductive package connectors on a second major side of the packaging substrate, the second major side opposite of the first major side of the packaging substrate. The plurality of grooves may be formed on a second major side of the packaging substrate, the second major side opposite of the first major side of the packaging substrate.

In another embodiment, there is provided, a method of manufacturing a semiconductor device packaging panel including forming a packaging substrate having a plurality of grooves orthogonally arranged and substantially surrounding a plurality of package sites; for each package site of the plurality of package sites, affixing a semiconductor die within a respective package site; and encapsulating with an encapsulant a first major side of the packaging substrate, each semiconductor die of the plurality of semiconductor die encapsulated by the encapsulant. The encapsulating with the encapsulant may include substantially filling the plurality of grooves with encapsulant. Each semiconductor die may be interconnected to the packaging substrate by way of bond wires. The method may further include forming a singulation cut along each groove of the plurality of grooves of the packaging substrate to form individual semiconductor device units A width of the singulation cut may be narrower than a width of each groove of the plurality of grooves. The forming the singulation cut may include forming the singulation cut by way of laser ablating or mechanical sawing.

In yet another embodiment, there is provided, a method of manufacturing a semiconductor device packaging panel including forming a packaging substrate having a plurality of grooves and a plurality of package sites, the plurality of grooves orthogonally arranged and substantially surrounding each package site of the plurality of package sites; for each package site of the plurality of package sites, affixing a semiconductor die within a respective package site on a first major side of the packaging substrate; encapsulating with an encapsulant the first major side of the packaging substrate, each semiconductor die of the plurality of semiconductor die encapsulated by the encapsulant; and forming a singulation cut through each groove of the plurality of grooves of the packaging substrate to form individual semiconductor device units. A width of the singulation cut may be narrower than a width of each groove of the plurality of grooves. The packaging substrate may include a core layer and a solder mask layer, the core layer proximate to the first major side of the packaging substrate. Each groove of the plurality of grooves may extend through the solder mask layer of the packaging substrate. The method may further include affixing a plurality of conductive package connectors on a second major side of the packaging substrate, the plurality of conductive package connectors arranged in a ball grid array.

By now, it should be appreciated that there has been provided, a semiconductor device packaging process for panel warpage control. The packaging process for a panel includes a forming a plurality of grooves on a packaging substrate of the panel. The packaging substrate of the panel includes a plurality of packaging sites arranged in a grid of rows and columns. Each packaging site corresponds to a singulated individual semiconductor device unit after subsequent stages of manufacture, for example. The plurality of grooves is configured and arranged to surround each individual packaging site of the packaging substrate. The grooves are formed having predetermined width and depth dimensions chosen to compensate for CTE mismatches and thereby control panel warpage during subsequent stages of manufacture. A plurality of semiconductor die is mounted on the packaging substrate such that each packaging site includes at least one semiconductor die. Each semiconductor die of the plurality of semiconductor die is interconnected with conductive features of the packaging substrate. An encapsulant is formed over the plurality of semiconductor die and the top side of the packaging substrate. Singulation cuts are formed along the grooves to singulate the package sites and form the individual semiconductor device units. By forming semiconductor device panels in this manner, panel warpage is substantially controlled and mitigated with minimal costs.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method of manufacturing a semiconductor device packaging panel, the method comprising:
forming a packaging substrate having a plurality of grooves orthogonally arranged and substantially surrounding a plurality of package sites;
affixing a plurality of semiconductor die on a first major side of the packaging substrate, each semiconductor die of the plurality of semiconductor die affixed at a unique package site of the plurality of package sites;
encapsulating with an encapsulant the first major side of the packaging substrate, each semiconductor die of the plurality of semiconductor die encapsulated by the encapsulant; and
forming a singulation cut along each groove of the plurality of grooves of the packaging substrate to form individual semiconductor device units.

2. The method of claim **1,** wherein the plurality of grooves is formed on the first major side of the packaging substrate.

3. The method of claim 1 or claim 2, wherein each semiconductor die of the plurality of semiconductor die is interconnected to the packaging substrate by way of bond wires.

4. The method according to any preceding claim, wherein a width of the singulation cut is narrower than a width of each groove of the plurality of grooves.

5. The method according to any preceding claim, wherein the packaging substrate includes a core layer and a solder mask layer, the core layer proximate to the first major side.

6. The method of claim 5, wherein each groove of the plurality of grooves extends through the core layer of the packaging substrate.

7. The method of claim 5, wherein a portion of the encapsulant encapsulates sidewalls of the core layer after the singulation cut.

8. The method according to any preceding claim, further comprising affixing a plurality of conductive package connectors on a second major side of the packaging substrate, the second major side opposite of the first major side of the packaging substrate.

9. The method according to any preceding claim, wherein the plurality of grooves is formed on a second major side of the packaging substrate, the second major side opposite of the first major side of the packaging substrate.
